# EUROPÄISCHE PATENTANMELDUNG

(11) **EP 1 303 173 A2**
(43) Veröffentlichungstag der Anmeldung: **16.04.2003**
(21) Anmeldenummer: 02021989.5
(22) Anmeldetag: 30.09.2002
(51) Int. Cl.: H05K 7/14

(54) **Server**

(30) Priorität: 09.10.2001 DE 10149743
(71) Anmelder: Fujitsu Siemens Computers GmbH, 81739 München (DE)
(72) Erfinder: Paland, Rolf-Heinrich, 34393 Grebenstein (DE); Gockel, Ludger, 33100 Paderborn (DE)
(74) Vertreter: Epping Hermann & Fischer

(57) **Zusammenfassung**

Die Erfindung betrifft einen Server, insbesondere in Form eines Einschubes zur Aufnahme in einem Serverrack, wobei im Frontbereich des Servers (1) eine LCD-Anzeige (5) angeordnet ist, welche an einem in den Server (1) einschiebbaren Basisteil (6) festgelegt ist.

## Beschreibung

Die Erfindung betrifft einen Server, insbesondere in Form eines Einschubes zur Aufnahme in einem Serverrack.

Bei Servern, die in 19"-Racks eingebaut werden, wird die Höhe in Höheneinheiten angegeben. Eine Höheneinheit entspricht 44,45 mm. Um möglichst viele Server in einem Rack unterzubringen, ist man stets bemüht, diese so kompakt wie möglich zu bauen.

Im Frontbereich der Server werden die Bedienelemente wie Diskettenlaufwerke (Floppy), CD-ROM-Laufwerke, Festplatten und so weiter angeordnet.

Hier ist man daher bestrebt, möglichst viele Peripheriegeräte unterzubringen, wobei ein optimaler Bedienkomfort gewährleistet sein soll.

Viele Kunden wünschen bei Servern auch eine LCD-Anzeige, anhand welcher die Systeminformationen abgelesen werden können.

Eine LCD-Anzeige muß jedoch genügend groß ausgebildet sein, um auf ihr die Informationen leserlich darstellen zu können und andererseits ebenfalls an der Frontseite des Servers angeordnet sein. Durch eine LCD-Anzeige müßten somit einige andere Bedienelemente wie z.B. CD-ROM-Laufwerke oder Festplatten entfallen, um diese in der Frontseite des Servers anordnen zu können.

Aufgabe der Erfindung ist es daher, eine LCD-Anzeige in einem Server zu integrieren und hierbei einen möglichst geringen Bereich im Frontbereich des Servers zu beanspruchen.

Diese Aufgabe wird erfindungsgemäß dadurch gelöst, daß der Frontbereich eine LCD-Anzeige aufweist, welche an einem einschiebbaren Basisteil festgelegt ist.

Die LCD-Anzeige kann somit über das Basisteil in den Server eingesteckt werden. Die LCD-Anzeige verdeckt im eingesteckten Zustand zum Beispiel einen anderen Einschub wie eine Wechselfestplatte. Möchte man diese Wechselfestplatte wechseln, so entfernt man die LCD-Anzeige mit Basisteil, so daß der Einschub für die Wechselfestplatte freigegeben ist.

Eine alternative Ausführungsform sieht vor, daß das Basisteil schubladenartig in Server ein- und ausfahrbar ist, und die LCD-Anzeige scharnierartig zum Basisteil schwenkbar ist.

Auch gemäß dieser Ausführungsform verdeckt die LCD-Anzeige eine weitere Einschubkomponente, wie zum Beispiel eine Wechselfestplatte.

Um die Wechselfestplatte wechseln zu können, wird die LCD-Anzeige lediglich nach oben geschwenkt.

Durch die Schwenkbarkeit der LCD-Anzeige wird zum einen eine sehr dichte Anordnung im Server erreicht, da die LCD-Anzeige weitere Einbauplätze abdecken kann und zum anderen wird erzielt, daß bei einer Anordnung des Serverracks tief unten die LCD-Anzeige so geschwenkt werden kann, daß ein Benutzer sie immer optimal einsehen kann. Bei einer Anordnung des Servers weit oben im Serverrack wird der Einschub leicht herausgezogen und die LCD-Anzeige so geschwenkt, daß der Anzeigebereich schräg nach unten in Richtung des Betrachters zeigt und diese ebenfalls wieder optimal abgelesen werden kann.

Eine weitere Ausbildung der Erfindung sieht vor, daß die LCD-Anzeige in die Ebene des Basisteiles schwenkbar ist und komplett in den Server mit dem Basisteil eingeschoben werden kann. Diese Ausführung hat den Vorteil, daß die LCD-Anzeige geschützt im Server aufgenommen ist, sofern sie nicht benötigt wird und keine weiteren Komponenten wie zum Beispiel die darunter angeordnete Wechselfestplatte von ihr verdeckt werden.

Um eine möglichst kompakte Baudichte im Server zu erreichen, weist sowohl das Basisteil als auch die LCD-Anzeige lediglich die Höhe eines schmalen Floppy- beziehungsweise CD-ROM-Laufwerkes auf, und ist neben diesen Einheiten im Server angeordnet.

Durch diese Ausbildung ist es möglich, in einer Höheneinheit eines Servers drei Festplatten, ein Floppy-Laufwerk, ein CD-ROM-Laufwerk und eine LCD-Anzeige unterzubringen.

In einem Server mit zwei Höheneinheiten können drei Festplattenlaufwerke mehr als insgesamt sechs Festplattenlaufwerke, ein Floppy-Laufwerk, ein CD-ROM-Laufwerk und eine LCD-Anzeige untergebracht werden.

Um auf der LCD-Anzeige möglichst viele verschiedene Informationen abrufen zu können beziehungsweise Einstellungen vornehmen zu können, ist neben der LCD-Anzeige vorzugsweise ein Bedienfeld angeordnet.

Nachfolgend wird anhand zweier in den Zeichnungen dargestellten Ausführungsbeispielen die Erfindung näher erläutert. In den Zeichnung zeigen:
- Figur 1: eine Schrägansicht eines Servers mit eingesteckter LCD-Anzeige,
- Figur 2: die Darstellung gemäß Figur 1 mit einer leicht nach unten geschwenkten LCD-Anzeige,
- Figur 3: die Darstellung gemäß Figur 1 mit einer vollkommen eingeschobenen LCD-Anzeige,
- Figur 4: die Darstellung gemäß Figur 1 mit einer schräg nach oben zeigenden LCD-Anzeige,
- Figur 5: ein Server mit zwei Höheneinheiten mit eingesteckter LCD-Anzeige und
- Figur 6: die Darstellung gemäß Figur 5 mit einer um 90° geschwenkten LCD-Anzeige.

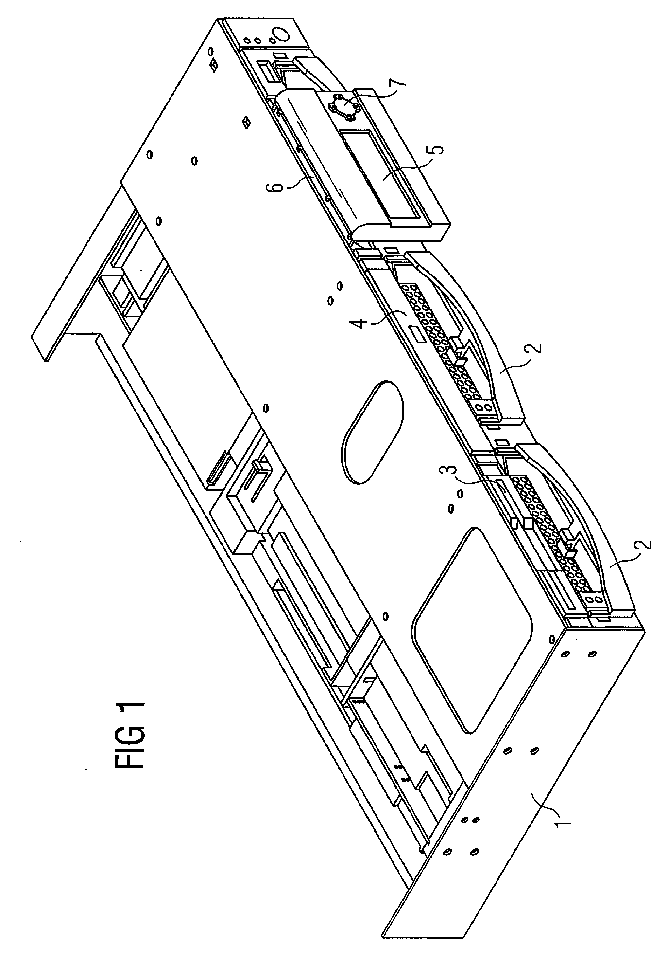

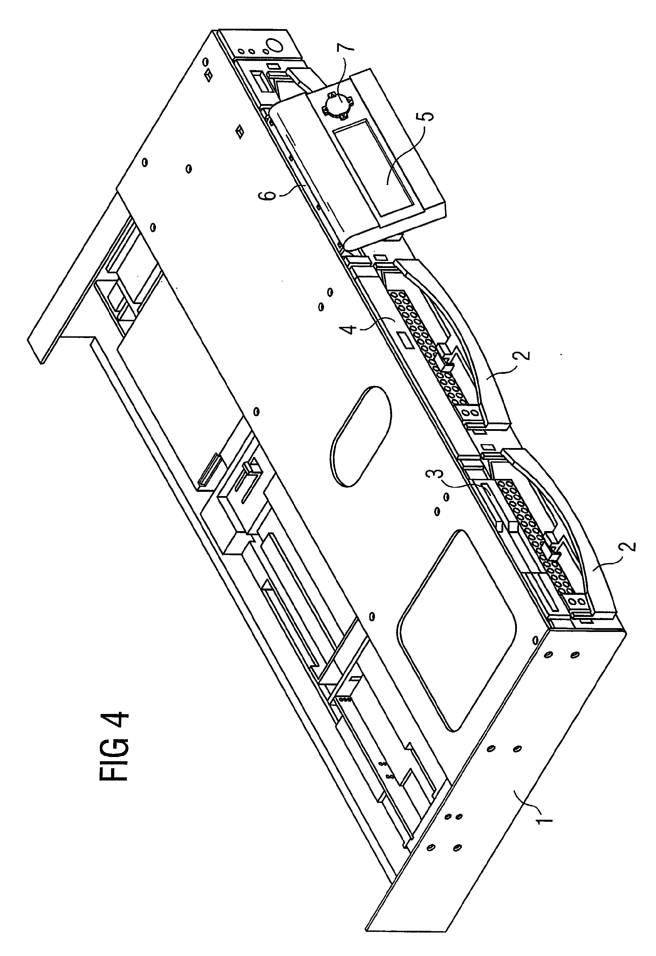

Die Figuren 1 bis 6 zeigen jeweils in Schrägansicht einen Server 1 in Form eines Einschubes, zur Aufnahme in einem Serverschrank.

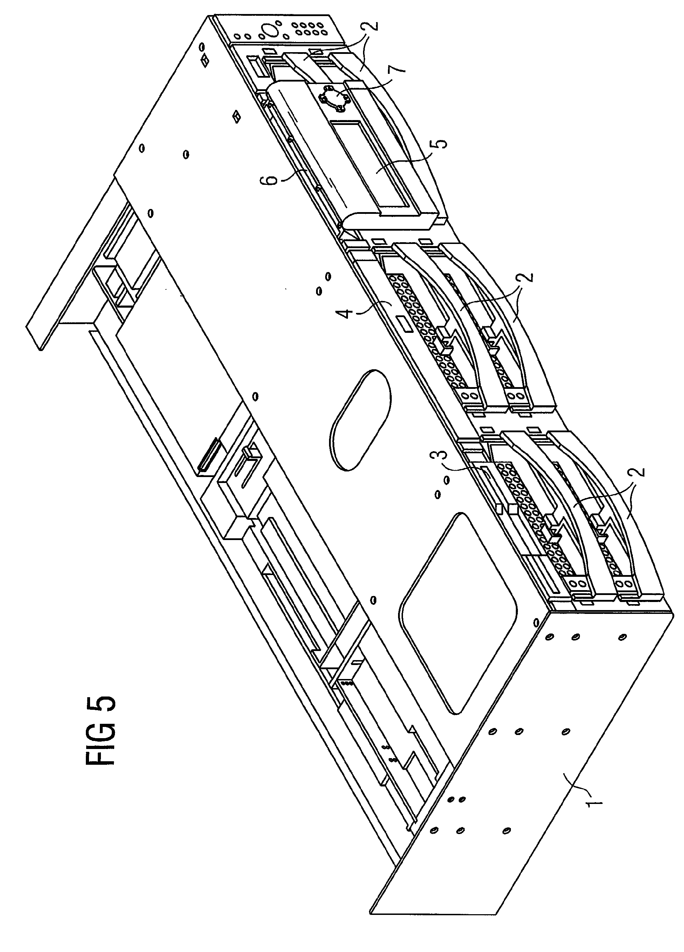

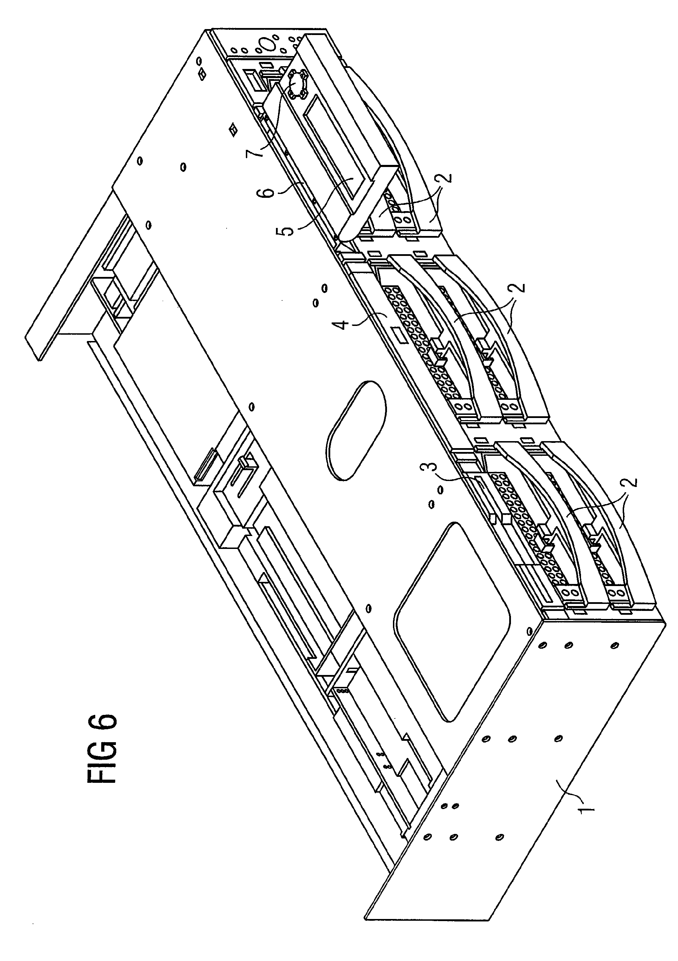

Bei Servern, die 19"-Racks eingebaut werden, wird die Höhe in Höheneinheiten angegeben. Eine Höheneinheit entspricht 44,45 mm. In den Figuren 1 bis 4 sind jeweils Server 1 mit einer Höheneinheit und in den Figuren 5 und 6 Server mit zwei Höheneinheiten dargestellt.

Um möglichst viele Server in einem Rack unterzubringen, werden diese so kompakt wie möglicht gebaut.

In den Server mit einer Höheneinheit gemäß den Figuren 1 bis 5 sind im Frontbereich jeweils drei Festplattenlaufwerke 2, ein Floppy- beziehungsweise Diskettenlaufwerk 3, ein CD-ROM-Laufwerk 4 sowie eine LCD-Anzeige 5 angeordnet.

Die LCD-Anzeige 5 ist im dargestellten Ausführungsbeispiel schwenkbar an einem Basisteil 6 befestigt, welches ungefähr die Dicke eines schmalen Floppy- beziehungsweise CD-ROM-Laufwerkes aufweist und in den Server einsteckbar ist.

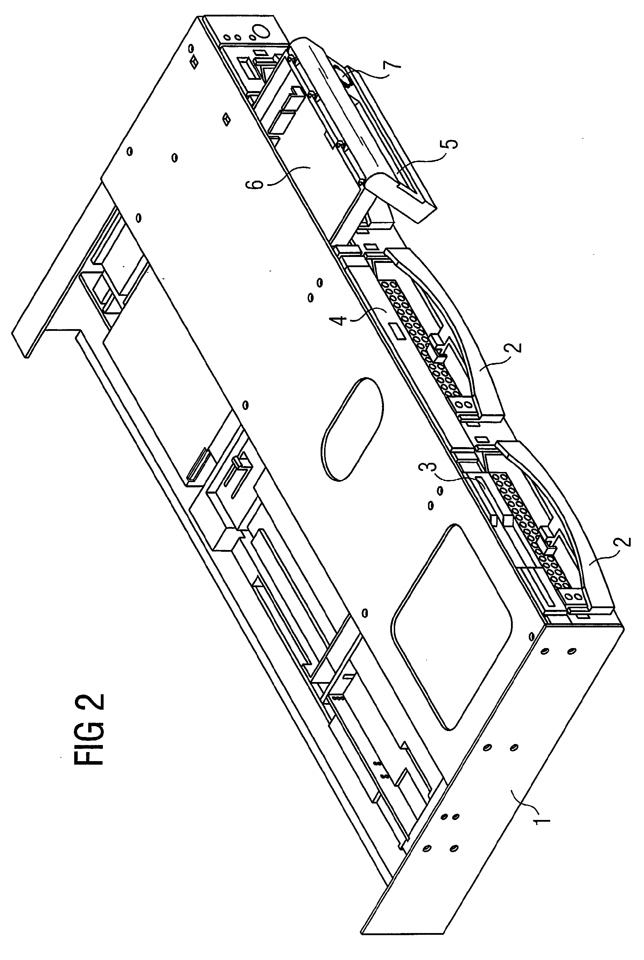

Das Basisteil 6 kann wie in Figur 2 dargestellt, schubladenartig in den Server eingeschoben beziehungsweise herausgezogen werden, um die LCD-Anzeige 5 in die gewünschte Lage zu schwenken. Ist der Server 1 zum Beispiel auf Augenhöhe angeordnet, so wird die Lage gemäß Figur 1 gewählt, ist der Server weiter oben im Rack angeordnet, so wird das Basisteil 6 leicht herausgezogen und die LCD-Anzeige wie in Figur 2 dargestellt, mit Ausrichtung nach unten geschwenkt und ist der Server 1 weit unten im Rack angeordnet, so wird die LCD-Anzeige wie in Figur dargestellt, leicht nach oben geschwenkt.

Hierdurch ist gewährleistet, daß der Benutzer die Informationen auf der LCD-Anzeige 5 immer im idealen Blickwinkel einsehen kann.

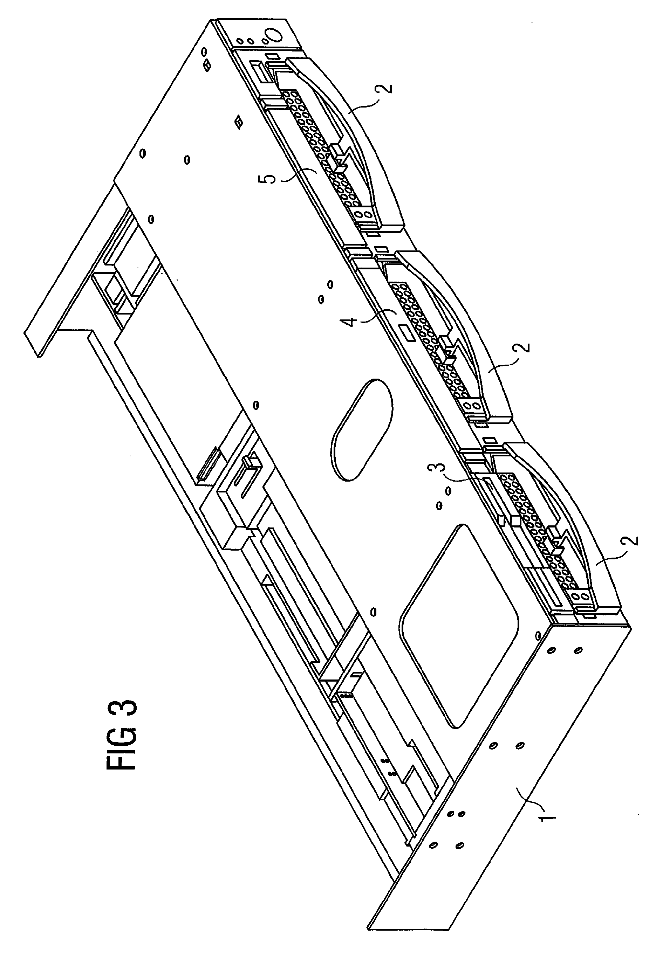

Wird die LCD-Anzeige 5 nicht benötigt, so kann sie wie in Figur 3 dargestellt, komplett mit dem Basisteil 6 in den Server 1 eingeschoben werden. Diese Stellung ist zum Beispiel auch günstig, wenn Festplatte 2 unterhalb der LCD-Anzeige 5 gewechselt wird. Alternativ ist es auch möglich, die LCD-Anzeige 5 lediglich nach oben wegzuklappen.

Ebenso ist es auch möglich, das Basisteil mit der LCD-Anzeige 5 komplett aus dem Server zu entnehmen.

Gemäß einer einfacheren nicht dargestellten Ausführungsform ist die LCD-Anzeige 5 am Basisteil 6 nicht scharnierartig befestigt und muß, um den Zugang zu der darunterliegenden Wechselfestplatte 2 zu ermöglichen, herausgenommen werden.

Die Figuren 5 und 6 zeigen ein alternatives Ausführungsbeispiel der Erfindung, wobei hier der Server 1 zwei Höheneinheiten umfaßt und daher in dem Server statt von drei Festplattenlaufwerken 2 sechs Festplattenlaufwerke 2 integriert sind.

Die LCD-Anzeige 5 sowie das Basisteil 6 sind ebenso wie im ersten Ausführungsbeispiel gemäß den Figuren 1 bis 4 ausgeführt. Die LCD-Anzeige wird wie in Figur 6 dargestellt, fluchtend zum Basisteil 6 geklappt, um sie vollkommen in den Server 1 einschieben zu können.

Um an der LCD-Anzeige möglichst viele Informationen abrufen zu können, ist neben dieser ein Bedienfeld 7 in Form eines Navigationsbuttons ausgebildet. Über den Navigationsbutton können auch Eingaben vorgenommen werden.

## Patentansprüche

1. Server (1), insbesondere in Form eines Einschubes zur Aufnahme in einem Serverrack,
**dadurch gekennzeichnet, daß**
der Frontbereich des Servers eine LCD-Anzeige (5) aufweist, welche an einem in den Server einschiebbaren Basisteil (6) festgelegt ist.

2. Server nach Anspruch 1,
**dadurch gekennzeichnet, daß**
das Basisteil (6) in den Server einsteckbar ist.

3. Server nach Anspruch 1,
**dadurch gekennzeichnet, daß**
das Basisteil (6) schubladenartig ein- und ausfahrbar ist.

4. Server nach einem der Ansprüche 1 bis 3,
**dadurch gekennzeichnet, daß**
die LCD-Anzeige (5) scharnierartig zum Basisteil (6) schwenkbar ist.

5. Server nach einem der Ansprüche 1 bis 4,
**dadurch gekennzeichnet, daß**
die LCD-Anzeige (5) zusammen mit dem Basisteil (6) in den Server (1) komplett einschiebbar ist.

6. Server nach einem der Ansprüche 1 bis 5,
**dadurch gekennzeichnet, daß**
das Basisteil (6) in der Höhe eines Diskettenlaufwerkes (3) beziehungsweise CD-ROM-Laufwerkes (4) ausgebildet ist.

7. Server nach einem der Ansprüche 1 bis 6,
**dadurch gekennzeichnet, daß**
in einem Servereinschub mit einer Höheneinheit gleich 44,45 mm drei Festplattenlaufwerke, ein Diskettenlaufwerk, ein CD-ROM-Laufwerk und eine LCD-Anzeige angeordnet sind.

8. Server nach einem der Ansprüche 1 bis 6,
**dadurch gekennzeichnet, daß**
in einem Servereinschub mit zwei Höheneinheiten drei Festplattenlaufwerke (2), ein Diskettenlaufwerk (3), ein CD-ROM-Laufwerk (4) und eine LCD-Anzeige (5) angeordnet sind.

9. Server nach einem der Ansprüche 1 bis 8,
**dadurch gekennzeichnet, daß**
die LCD-Anzeige (5) mit einem Bedienfeld (7) versehen ist.
